(19) Europäisches Patentamt
European Patent Office
Office européen des brevets

(11) EP 0 519 564 B1

## (12) FASCICULE DE BREVET EUROPEEN

(45) Date de publication et mention
de la délivrance du brevet:
**17.09.1997 Bulletin 1997/38**

(51) Int Cl.6: **G06K 19/06**

(21) Numéro de dépôt: **92201745.4**

(22) Date de dépôt: **15.06.1992**

(54) **Procédé de fabrication d'une carte à micro-circuit et carte à micro-circuit**

Verfahren zur Herstellung einer Mikroschaltungskarte und Mikroschaltungskarte

Method for the manufacture of a microcircuit card and microcircuit card

(84) Etats contractants désignés:
**DE FR GB IT**

(30) Priorité: **17.06.1991 FR 9107371**

(43) Date de publication de la demande:
**23.12.1992 Bulletin 1992/52**

(73) Titulaires:
• **PHILIPS CARTES ET SYSTEMES**
**75013 Paris (FR)**
Etats contractants désignés:
**FR**
• **Philips Electronics N.V.**
**5621 BA Eindhoven (NL)**
Etats contractants désignés:
**DE GB IT**

(72) Inventeur: **Venambre, Jacques**
**F-75008 Paris (FR)**

(74) Mandataire: **Barbin le Bourhis, Joel**
**Cabinet Bonnet-Thirion,**
**12, Avenue de la Grande-Armée**
**75017 Paris (FR)**

(56) Documents cités:
**EP-A- 0 334 733          EP-A- 0 412 545**
**CH-A- 619 333           FR-A- 2 613 510**

## Description

La présente invention a pour objet un procédé de fabrication d'une carte à microcircuit comportant un support de carte présentant un logement dans lequel est fixé un module électronique, ledit module présentant un support de circuit et au moins un microcircuit disposé sur une face inférieure du support de circuit dirigée vers l'intérieur du logement et étant espacée de la face interne du fond du logement, procédé dans lequel un produit d'enrobage est déposé sur ladite face interne.

Un tel procédé est connu de la demande de brevet européen 201952 déposée le 10 avril 1986 par la Demanderesse (et de la demande FR-A-2 613 510). Selon cette antériorité, une pipette doseuse automatique dépose dans le logement de la carte une quantité déterminée d'un produit d'enrobage, après quoi la vignette (module électronique) est posée et la carte est retournée. Le produit d'enrobage coule alors sur la pastille de circuit intégré, mais est maintenu dans le logement puisque ce dernier est fermé par la vignette. Ce procédé permet d'améliorer la tenue en flexions répétées de la carte, mais n'assure pas toutefois un enrobage reproductible du circuit. Or, il est souhaitable de pouvoir enrober complètement le circuit intégré et ses fils de connexion pour assurer une fiabilité optimale de la carte.

Des techniques d'enrobage total d'une carte à microcircuit sont par ailleurs connues, mais elles présentent toutes des inconvénients assez importants, en particulier un nombre assez élevé d'étapes de procédés.

La demande de brevet européen 075351, déposé le 7 septembre 1982 par la Demanderesse et N.V. PHILIPS, enseigne de disposer un circuit intégré au fond d'une cavité d'un support et qui est connecté électriquement à des trajets métallisés sur les deux faces du support auxiliaire. La cavité est ensuite remplie d'une cire isolante qui, une fois durcie, maintient le circuit intégré et les fils de connexion. On emploie à cet effet un cadre qui est posé sur le support 11 et entoure la cavité. L'ensemble ainsi obtenu ne présente donc pas une surface plane puisque le cadre forme une surépaisseur et le procédé n'est de toutes façons pas transposable à une carte selon l'antériorité 201952.

On connait également du brevet européen 107061 (N.V. PHILIPS) une carte présentant un support de carte pourvu d'une cavité débouchant sur les deux faces de la carte. Un support de circuit (4) est recouvert sur sa face inférieure d'une feuille (6), le circuit (5) est disposé sur la feuille (6) à travers une ouverture (10) du support de circuit, et des fils de connexion sont ensuite disposés entre le circuit et le support de circuit. Un élément d'étanchéité annulaire (8) est alors disposé sur le support de circuit de manière à entourer le circuit et les fils de connexion et on coule ensuite une matière de remplissage (9) de manière à noyer le circuit et les fils, et on enlève ensuite la feuille (6). Ce procédé présente l'inconvénient que le remplissage par la résine ne permet pas d'obtenir une surface plane d'une part en raison de la précision que l'on peut obtenir des pipettes de dosage automatiques, et d'autre part en raison de la capillarité. Une opération d'aplanissement de la carte par usinage est donc nécessaire. Cet inconvénient est commun à toutes les techniques de remplissage de cavités par l'arrière. C'est ainsi que les cartes fabriquées par la Société SCHLUMBERGER utilisent un support de carte présentant un trou dans lequel est disposé un circuit imprimé polyester MCTS portant un circuit intégré, le remplissage par une résine époxy étant effectué par la face arrière et étant ensuite suivi d'une opération d'usinage de l'excédent de résine. On notera également que ce procédé, de par les matériaux employés, présente l'inconvénient que le composant est visible d'où un problème d'aspect du produit.

Une autre technologie d'enrobage total est mise en oeuvre par SIEMENS. Un cristal est interconnecté à un film par des surépaisseurs d'or et est disposé dans une cavité d'une couche interne d'un support de carte présentant une pluralité de couches de PVC. Cette technique nécessitant un empilement de plusieurs couches est coûteuse à mettre en oeuvre.

La présente invention se propose de résoudre le problème de coût de fabrication des cartes à "enrobage total".

Jusqu'à présent, la technologie correspondant au brevet européen 201952 a été mise en oeuvre en n'enrobant que partiellement ou même pas du tout les fils d'interconnexion, le produit étant conçu de manière à assurer sa tenue mécanique lors des tests de flexion. On se rapportera par exemple à la demande de brevet français FR 2617668 (RTC - COMPELEC). Le support de carte selon cette technologie peut être réalisé à faible coût (par moulage) et l'encartage tel que décrit dans le brevet européen 201952 est particulièrement facile à automatiser.

Une technologie connue d'enrobage total et applicable à une carte présentant un logement pour une vignette consiste à disposer et polymériser une goutte de résine époxy sur un composant intégré de manière à enrober l'ensemble composant - fils de connexion (voir la demande de brevet français publiée sous le numéro FR 2583574 et déposée le 14 juin 1985 par la Société EUROTECHNIQUE). Un usinage mécanique est, en pratique, nécessaire car la goutte déposée forme un dôme de hauteur H, hauteur qui doit être réduite en pratique pour que l'épaisseur de l'empilement circuit imprimé - composant - enrobage ne dépasse pas les limites imposées aux caractéristiques dimensionnelles d'une carte à microcircuit (épaisseur nominale 0.8 mm). Cette réduction de hauteur est obtenue en pratique en usinant le dôme de manière à l'aplanir jusqu'à sensiblement le niveau des fils de connexion.

EP-A-0 334 733 expose une carte à mémoire comportant un module électronique présentant un support isolant sur lequel sont réalisés les contacts électriques. Une pastille semi-conductrice est fixée sur l'autre face du support isolant. La pastille et les fils de connection sont enrobés dans un matériau de protection. Le corps de la carte comporte un épaulement qui entoure une cavité. Un élément de fixation est déposé sur l'épaulement et une goutte d'un matériau adhésif est déposé sur le fond de la cavité. Le module est ensuite inséré dans la cavité et une pression est exercée sur le module.

EP-A-0 412 545 expose un emballage pour un circuit intégré et une carte comportant cet emballage. Le corps de l'emballage comporte une cavité dans laquelle est situé le circuit intégré. La cavité communique avec une rainure qui s'étend autour de la cavité. La cavité est remplie de résine epoxy et une plaque est appuyée contre le corps de l'emballage. Ainsi, l'excès de la résine dans la cavité est éjecté dans la rainure. Ensuite, l'emballage comprenant le circuit intégré peut être collé dans une cavité du corps de la carte.

L'idée de base de l'invention est de mettre en oeuvre le procédé de fabrication mentionné en premier lieu (p 1 § 1) dans la présente demande de brevet, pour réaliser des cartes à enrobage total, en évitant toute étape d'usinage, et sans imposer de valeur particulière à l'épaisseur de la carte.

Un procédé selon l'invention est dans ce but caractérisé en ce qu'il comporte les étapes suivantes :

a) disposer une quantité dosée dudit produit d'enrobage sur une première portion de la face interne du fond du logement entourée par une région de surépaisseur, la région de surépaisseur étant elle-même entourée d'une deuxième portion de ladite face interne, de telle sorte que le produit d'enrobage est retenu par la capillarité par la région de surépaisseur, laquelle est agencée pour être espacée, sur au moins une partie de son pourtour, du module lorsque ce dernier est fixé sur le support de carte,

b) disposer le module sur le support de carte, le produit d'enrobage venant remplir complètement un premier volume compris entre ladite première portion et le module et partiellement un deuxième volume compris entre ladite deuxième portion et le module.

Le deuxième volume qui entoure la région de surépaisseur sert à absorber l'excédent de produit d'enrobage, lequel se dépose sur la deuxième portion de ladite face interne, ce qui la renforce mécaniquement. Les étapes de fabrication sont simplifiées au maximum et aucun rodage n'est bien entendu nécessaire. Un durcissement du produit d'enrobage est avantageusement réalisé à température ambiante. En effet, la cavité étant fermée par la vignette (module électronique), il est possible de tester, et de trier la carte avant durcissement du produit d'enrobage, lequel a pour fonction de protéger la carte seulement lorsqu'elle est soumise à des sollicitations mécaniques importantes. Le produit d'enrobage est avantageusement une résine semi-rigide (ex : dureté Shore D 70) de manière à suivre les pliages de la carte imposés par les tests de pliage (Ex : Résine epoxy ME45W de EMERSON and CUMING France).

Selon un mode de réalisation préféré assurant la meilleure tenue mécanique, la première portion est telle que le microcircuit et les fils de connexion électrique de celui-ci au support de circuit sont entièrement enrobés par le produit d'enrobage.

L'invention concerne également une carte à microcircuit comportant un support de carte présentant un logement dans lequel est fixé un module électronique, ledit module présentant un support de circuit et au moins un microcircuit disposé sur une face inférieure du support de circuit dirigée vers l'intérieur du logement et étant espacée de la face interne du fond de logement.

Une telle carte est connue de l'antériorité EP 201952 précitée.

Selon l'invention, la face interne du fond du logement comporte une région de surépaisseur espacée du module sur au moins une partie de son pourtour, la région de surépaisseur entourant une première portion de ladite face interne et étant elle-même entourée par une deuxième portion de ladite face interne, un premier volume compris entre ladite première portion et le module étant entièrement rempli d'un produit d'enrobage, et un deuxième volume compris entre ladite deuxième portion et le module étant partiellement rempli par ledit produit d'enrobage.

Le deuxième volume sert de réservoir d'expansion au premier volume lequel est entièrement rempli par le produit d'enrobage.

Selon un mode de réalisation préféré correspondant à un enrobage total, la première portion s'étend au moins à l'aplomb des points de soudure sur le support de circuit des fils de connexion entre le circuit et le support de circuit.

Selon un mode de réalisation avantageux, le produit de remplissage remplissant partiellement le deuxième volume recouvre entièrement ladite deuxième portion.

La région de surépaisseur peut être annulaire et/ou avec une section triangulaire.

Ladite première portion peut comporter des éléments d'ancrage, permettant de mieux solidariser mécaniquement l'ensemble.

L'invention sera mieux comprise à la lecture de la description qui va suivre, en regard des dessins annexés représentant des exemples non limitatifs :

- la figure 1 représente une coupe partielle d'un support de carte selon l'invention,
- la figure 2 représente en coupe partielle ledit support de carte après remplissage par le produit d'enrobage (étape a),
- la figure 3 représente en coupe partielle la carte à microcircuit terminée,
- la figure 4 représente une vue de dessus du logement du support de carte sur lequel sont également représentés les points de soudure fil et le circuit 30,
- et la figure 5 une variante de la figure 4.

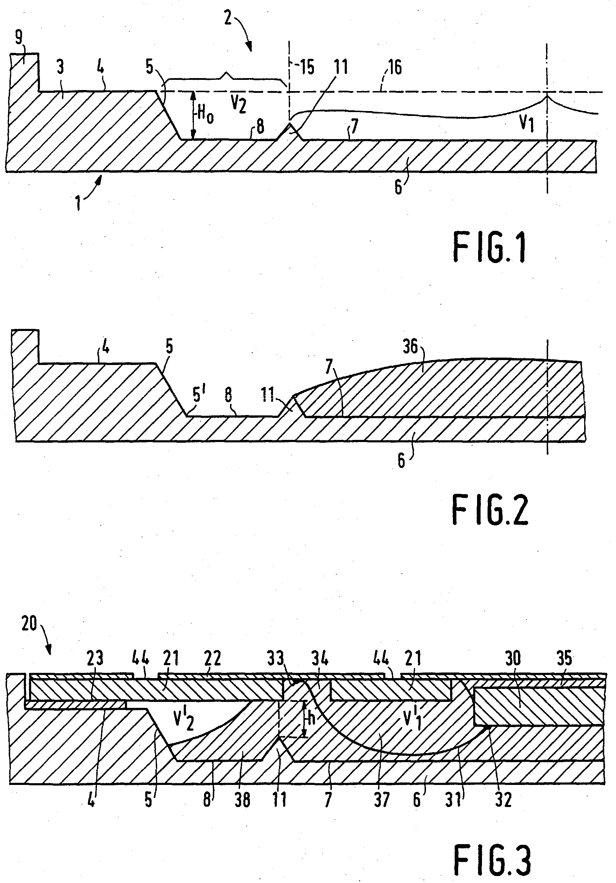

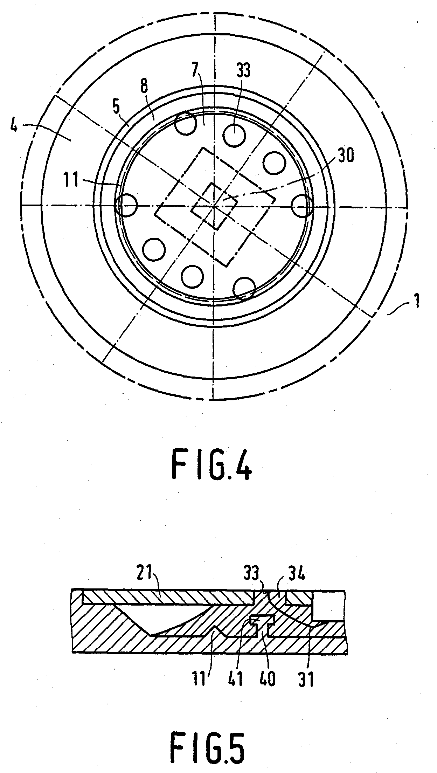

La figure 1 représente en coupe un support de carte désigné par le repère général 1 et comportant un logement, désigné par le repère général 2, ménagé dans un corps de carte 9. Le logement 2 est destiné à recevoir une vignette (module électronique) désignée par le repère général 20 sur la figure 3 et comportant un microcircuit 30 et un support de microcircuit 21. Le logement 2 présente un anneau extérieur 4 destiné à la fixation de la vignette 20 par une colle 23 (figure 3), relié à la face interne du fond 6 du logement 2 par une partie tronconique 5 (voir également la figure 4). Une région de surépaisseur 11 forme une barrière annulaire de section triangulaire et entoure en le délimitant une partie circulaire 7 de la face interne du fond 6 du logement 2. Une partie annulaire 8 de la face interne du fond 6 entoure la région de surépaisseur 11 et s'étend donc jusqu'au pied 5' de la partie tronconique 5. Une vignette 20 présente un support de circuit 21 en matériau isolant et une couche conductrice 22 présentant des trajets conducteurs séparés par des ouvertures telles que 44 les séparant électriquement en différentes zones permettant d'isoler les prises de contact électrique. Un microcircuit 30 est collé en 35 sur la couche 22. Des fils de connexion 31 sont soudés entre le microcircuit 30 (en 32) et le film 22 (en 34). Une description plus détaillée sera trouvée dans la demande de brevet français FR 2580416 déposée le 12 avril 1985 par la Demanderesse.

La figure 2 représente la première étape de l'encartage. Une quantité prédéterminée d'un produit d'enrobage, par exemple la résine epoxy à deux composants ME45W de EMERSON and CUMING (résine semi-rigide prévue notamment pour les cartes à microcircuit) et préparée à raison de 100 parties de partie A et 40 parties de partie B, est déposée de manière à former par capillarité un dôme 36 sur la partie 7 du fond 6, sans toutefois déborder à l'extérieur grâce à la surépaisseur 11. On utilise un système de dépose volumétrique, de préférence multi-aiguille pour une bonne répartition de la goutte formant le dôme 36.

On définit par $V_1$ le volume délimité par la partie 7, par le cylindre 15 s'appuyant sur le sommet de la surépaisseur 11, et par le plan 16 de l'anneau extérieur 4, et par $V_2$ le volume délimité par la partie 8, par le cylindre 15, par la partie tronconique 5 et par le plan 16. Soit $H_o$ la distance entre le plan 16 et la face interne (7,8) du fond 6. Le volume du dôme 36 est supérieur à $V_1$ et est inférieur à $V_1 + V_2$ d'une quantité qui sera mieux explicitée à la figure 3. On remarquera que la mise en oeuvre d'une surépaisseur 11 annulaire pour retenir une goutte de résine est connue en soi du brevet suisse 619333 déposé le 1er novembre 1977 par FASELEC AG. Selon ce brevet, un semiconducteur est disposé à l'intérieur de l'espace annulaire défini par la surépaisseur et est enrobé par une résine qui s'appuie par capillarité sur la surépaisseur. Selon cette antériorité, une fois que la résine est déposée de manière à donner la forme désirée au dôme enrobant le composant, on fait polymériser la résine et l'enrobage est terminé. La résine garde donc sa forme de dôme, avec tous les inconvénients précités.

Selon l'invention au contraire, on dispose ensuite la vignette 20 sur la partie annulaire 4 de préférence grâce à une colle 23, le circuit 30 étant disposé vers l'intérieur du logement 2. Les vignettes 20 sont découpées par la machine d'encartage et sont positionnées au-dessus du logement 2 et appuyées sur le support de carte pour assurer une adhérence par l'adhésif transfert 23. L'excédent 38 de produit d'enrobage du dôme 36 déborde vers l'extérieur par-dessus le contour supérieur de la surépaisseur 11 (espacé de la vignette par la hauteur h) et vient se répandre sur la partie 8 sans toutefois venir mouiller la colle 23 éventuellement présente. Les bulles d'air éventuellement présentes dans le produit d'enrobage sont également chassées durant cette opération.

On appelle $V'_1$ le volume délimité par la partie 7, le cylindre 15, et la vignette 20 une fois posée. Le produit d'enrobage restant 37 remplit le volume $V'_1$. On appelle $V'_2$ le volume délimité par la partie 8, le cylindre 15, la partie tronconique 5 et la vignette 20. L'excédent 38 de produit d'enrobage doit ne remplir que partiellement le volume $V'_2$. En négligeant l'épaisseur de la colle 23, on peut dire que $V'_2$ est pratiquement égal à $V_2$. Par contre $V'_1$ est plus petit que $V_1$ en raison du circuit 30 qui s'étend à l'intérieur du logement 2 au-dessus de la partie 7 ($V'_1 < V_1$). La condition sur le volume du produit d'enrobage à déposer pour former le dôme 36 est

$$V_p < V'_1 + V'_2 \simeq V'_1 + V_2$$

soit $V_{IC}$ le volume du circuit 30. On peut alors écrire

$$V_p < V_1 + V_2 - V_{IC}$$

Il faudra bien entendu en pratique tenir compte des variations de volume de la résine lors de sa polymérisation.

Le collage de la vignette 20 dans le logement 2 rendant celui-ci hermétique, il n'est pas besoin de durcir rapidement le produit d'enrobage. Il faut bien entendu éviter de soumettre la carte à des contraintes mécaniques excessives avant que la polymérisation soit complète, mais il est possible de tester, trier, et stocker la carte. La résine ME45W précitée polymérise en 24 heures à température ambiante.

La région de surépaisseur 11 est séparée d'une hauteur h de la partie inférieure du support de circuit 21 une fois que celui-ci est monté dans le logement 2. Ceci permet au produit d'enrobage 36 de fluer vers le volume $V'_2$ situé au-dessus de la partie annulaire 8.

Il n'est donc de ce fait pas nécessaire que la surépaisseur 11 soit écartée de la vignette 20 sur tout son pourtour. Il suffit que la surépaisseur 11 présente une ou plusieurs régions de passage pour le produit d'enrobage 36.

On voit ainsi que, selon l'invention, on évite les inconvénients de l'art antérieur, en particulier la nécessité d'un usinage mécanique du produit d'enrobage, usinage ayant pour but que l'épaisseur de la carte reste dans les tolérances imposées.

Le support de carte 1 peut être réalisé en chlorure de polyvinyle le logement étant usiné, ou de préférence en matériau moulable (ABS).

Il est possible d'adapter les dimensions de la vignette, la forme et les dimensions du logement 2 pour recevoir de grands cristaux 30 ( $\simeq$ 20 mm2).

Les formes, notamment de la surépaisseur 11, ne sont pas nécessairement de révolution et peuvent être adaptées à la géométrie du composant et des ponts de soudure fil 33 de la vignette.

Il est préféré d'inclure les points soudure fil 33 de la vignette à l'intérieur du périmètre de la surépaisseur 11 (volume $V'_1$) (voir figure 4) de manière à être sûr d'enrober l'extrémité des fils 31. Ceci est une condition importante quant à la fiabilité du produit car un enrobage partiel d'un fil peut conduire à sa cassure lors des tests de pliage, une discontinuité d'enrobage conduisant à une augmentation brutale et localisée des contraintes sur le fil.

Exemple :

diamètre externe de l'anneau 4 : 16,3 mm,
diamètre interne de l'anneau 4 : 11,3 mm,
diamètre au pied 5' de la partie 5 : 10,7 mm,
diamètre interne de la région de surépaisseur 11 : 8,8 mm,
diamètre externe de la région de surépaisseur 11 : 9,4 mm,
hauteur des surépaisseurs 11 : 0,2 mm,
distance $H_o$ : 0,6 mm,
volume de résine déposé : environ 38 mm$^3$.

La résistance à l'écrasement du module vignette plus enrobage est excellente ce qui contribue à la fiabilité du produit, et permet d'éviter le problème des pertes magnétiques qu'auraient impliquées une déformation de la vignette 20 et du fond de carte 6 lors du passage dans des lecteurs de pistes magnétiques.

Le produit d'enrobage peut être chargé d'additifs visant à améliorer sa conduction thermique et/ou à protéger le composant des champs électrostatiques.

L'adhérence du produit d'enrobage peut être encore améliorée par la réalisation de pions d'ancrage (40, 41) dans le fond 6 de carte (figure 5), visant à augmenter la surface de contact entre la résine et le fond de carte.

D'autre part, la non-démontabilité de la vignette 20 (paramètre important pour certaines applications) est assurée par l'adhérence importante entre le produit d'enrobage 36 et le fond de carte 6. Toute tentative de décollement de la vignette 20 se solde par la destruction du dispositif (arrachement des fils 31 et décollement du cristal 30).

L'invention ne se limite pas aux modes de réalisation décrits et représentés. La région de surépaisseur 11 n'a pas besoin d'être fermée sur elle-même. Il suffit qu'elle puisse retenir par capillarité une goutte de produit de remplissage. Elle peut par exemple être constituée par une série de plots espacés les uns les autres et disposés sur un contour qui, lui, est fermé. L'espace entre les plots constitue alors l'espacement entre la région de surépaisseur 11 et la vignette.

L'invention s'applique à tous types de cartes y compris les cartes dites sans contact, lesquelles peuvent ne pas comporter de fils de connexion électrique.

Le terme carte n'est pas à prendre de manière stricte. L'invention s'applique également à tous types de supports plats comme par exemple des clés de télécommande de fermeture des véhicules automobiles.

**Revendications**

1. Procédé de fabrication d'une carte à microcircuit comportant un support (9) de carte présentant un logement (2) dans lequel est fixé un module électronique (20), ledit module présentant un support (21) de circuit et au moins un microcircuit (30) disposé sur une face inférieure du support de circuit dirigée vers l'intérieur du logement et étant espacée de la face interne (7,8) du fond du logement, procédé dans lequel un produit d'enrobage (36) est déposé sur ladite face interne caractérisé en ce qu'il comporte les étapes suivantes :

   a) disposer une quantité dosée dudit produit d'enrobage (36) sur une première portion (7) de la face interne du fond (6) du logement entourée par une région de surépaisseur (11), la région de surépaisseur (11) étant elle-même entourée d'une deuxième portion (8) de ladite face interne de telle sorte que le produit d'enrobage (36) est retenu par capillarité par la région de surépaisseur (11), laquelle est agencée pour être espacée sur au moins une partie de son pourtour, du module (20) lorsque ce dernier est fixé sur le support (9) de carte,
   b) disposer le module (20) sur le support (9) de carte, le produit d'enrobage (36) venant remplir complètement un premier volume ($V'_1$) compris entre ladite première portion (7) et le module (20) et partiellement un deuxième volume ($V'_2$) compris entre ladite deuxième portion (8) et le module (20).

2. Procédé selon la revendication 1 caractérisé en ce qu'un durcissement du produit d'enrobage (36) est réalisé à température ambiante.

3. Procédé selon une des revendications 1 ou 2 caractérisé en ce que le produit d'enrobage (36) est une résine semi-rigide.

4. Procédé selon une des revendications 1 à 3 caractérisé en ce que le premier volume ($V'_1$) est tel que le microcircuit (30) et des fils de connexion électriques (31) de celui-ci au support de circuit (21) sont entièrement enrobés par le produit d'enrobage.

5. Carte à microcircuit comportant un support (9) de carte présentant un logement (2) dans lequel est fixé un module électronique (20), ledit module présentant un support (21) de circuit et au moins un microcircuit (30) disposé sur une face inférieure du support de circuit dirigée vers l'intérieur du logement et étant espacée de la face interne (7,8) du fond du logement caractérisé en ce que la face interne du fond (6) du logement (2) comporte une région de surépaisseur (11) espacée du module (20) sur au moins une partie de son pourtour, la région de surépaisseur (11) entourant une première portion (7) de ladite face interne et étant elle-même entourée par une deuxième portion (8) de ladite face interne, un premier volume ($V'_1$) compris entre ladite première portion (7) et le module (20) étant entièrement rempli d'un produit d'enrobage (36), et un deuxième volume ($V'_2$) compris entre ladite deuxième portion (8) et le module (20) étant partiellement rempli par ledit produit d'enrobage (36).

6. Carte à microcircuit selon la revendication 5 caractérisé en ce que ladite première portion (7) s'étend au moins à l'aplomb des points de soudure (33) sur le support de circuit de fils de connexion électrique entre le circuit (30) et le support du circuit (21).

7. Carte à microcircuit selon une des revendications 5 ou 6 caractérisé en ce que le produit d'enrobage (36) remplissant partiellement le deuxième volume ($V'_2$) recouvre entièrement ladite deuxième portion (8).

8. Carte à microcircuit selon une des revendications 5 à 7 caractérisé en ce que la région de surépaisseur (11) est annulaire.

9. Carte à microcircuit selon une des revendications 5 à 8 caractérisé en ce que la région de surépaisseur (11) a une section triangulaire.

10. Carte à microcircuit selon une des revendications 5 à 9 caractérisé en ce que ladite première portion (7) comporte des éléments d'ancrage (40, 41).

11. Carte à microcircuit selon une des revendications 5 à 10 caractérisé en ce que la région de surépaisseur (11) est fermée sur elle-même.

## Claims

1. A method of manufacturing a chip card comprising a card base (9) having a recess (2) in which an electronic module (20) is secured, which module comprises a circuit support (21) and at least one microcircuit (30) arranged on a lower surface of the circuit support, which lower surface faces the interior of a recess and is spaced from the inner surface (7, 8) of the bottom of the recess, in which method an encapsulant (36) is applied to said inner surface, characterized in that it comprises the following steps:

   a) applying a metered amount of said encapsulant (36) to a first portion (7) of the inner surface of the bottom (6) of the recess, which first portion is surrounded by a raised area (11), which raised area (11) itself is surrounded by a second portion (8) of said inner surface in such manner that the encapsulant (36) is retained by capillarity by the raised area (11), which is adapted to be spaced, over at least a part of its circumference, from the module (20) when said module is secured to the card base (9),
   b) arranging the module (20) on the card base (9), the encapsulant (36) completely filling a first volume ($V'_1$) situated between said first portion (7) and the module (20) and partly filling a second volume ($V'_2$) situated between said second portion (8) and the module (20).

2. A method as claimed in Claim 1, characterized in that the encapsulant (36) is cured at ambient temperature.

3. A method as claimed in Claim 1 or 2, characterized in that the encapsulant (36) is a semi-rigid resin.

4. A method as claimed in any one of the Claims 1 to 3, characterized in that the first volume ($V'_1$) is such that the microcircuit (30) and electrical connection wires (31) between said microcircuit and the circuit support (21) are wholly encapsulated by the encapsulant.

5. A chip card comprising a card base (9) having a recess (2) in which an electronic module (20) is secured, which module comprises a circuit support (21) and at least one microcircuit (30) arranged on a lower surface of the circuit support, which lower surface faces the interior of the recess and is spaced from the inner surface (7, 8) of the bottom of the recess, characterized in that the inner surface of the bottom (6) of the recess (2) comprises a raised area (11) which is spaced from the module (20) over at least a part of its circumference, which raised area (11) surrounds a first portion (7) of said inner surface and is itself surrounded by a second portion (8) of said inner surface, a first volume (V'$_1$) situated between said first portion (7) and the module (20) being completely filled with an encapsulant (36), and a second volume (V'$_2$) situated between said second portion (8) and the module (20) being partly filled with said encapsulant (36).

6. A chip card as claimed in Claim 5, characterized in that said first portion (7) extends at least up to a location above which the circuit support carries solder points (33) for the electrical connection wires between the circuit (30) and the circuit support (21).

7. A chip card as claimed in Claim 5 or 6, characterized in that the encapsulant (36) which partly fills the second volume (V'$_2$) wholly covers said second portion (8).

8. A chip card as claimed in any one of the Claims 5 to 7, characterized in that the raised area (11) is annular.

9. A chip card as claimed in any one of the Claims 5 to 8, characterized in that the raised area (11) is of triangular cross-section.

10. A chip card as claimed in any one of the Claims 5 to 9, characterized in that said first portion (7) comprises anchor elements (40, 41).

11. A chip card as claimed in any one of the Claims 5 to 10, characterized in that the raised area (11) forms a closed figure.

**Patentansprüche**

1. Herstellungsverfahren für eine Mikroschaltungskarte mit einem Kartenträger (9) mit einer Lagerstelle (2), in der ein elektronisches Modul (20) befestigt wird, das einen Schaltungsträger (21) und wengistens eine Mikroschaltung (30) auf eine untere Fläche des Schaltungsträgers in Richtung auf das Innere der Lagerstelle aufweist und im Abstand von der Innenfläche (7, 8) des Lagerstellenbodens angebracht wird, und mit diesem Verfahren wird ein Einkapselungsprodukt (36) auf der Innenfläche angebracht, dadurch gekennzeichnet, daß das Verfahren folgende Schritte umfaßt:

   a) Anbringen einer dosierten Menge des Einkapselungsprodukts (36) auf einem ersten Anteil (7) der Innenfläche des Lagerstellenbodens (6), umgeben von einem Gebiet mit größerer Abmessung (11), wobei das Gebiet mit größerer Dicke (11) selbst von einem zweiten Anteil (8) der Innenfläche derart umgeben ist, daß das Einkapselungsprodukt (36) durch Kapillarität vom Gebiet mit größerer Dicke (11) festgehalten wird, das derart eingerichtet ist, daß es für wenigstens einen Teil seines Umfangs Raum bietet für das Modul (20), wenn es auf dem Kartenträger (9) befestigt wird,

   b) Anbringen des Moduls (20) auf dem Kartenträger (9), wobei das Einkapselungsprodukt (36) vollständig ein erstes Volumen (V'$_1$) zwischen dem ersten Anteil (7) und dem Modul (20) und teilweise ein zweites Volumen (V'$_2$) zwischen dem zweiten Anteil (8) und dem Modul (20) ausfüllt.

2. Verfahren nach Anspruch 1, dadurch gekennzeichnet, daß das Aushärten des Einkapselungsprodukts (36) bei Umgebungstemperatur erfolgt.

3. Verfahren nach einem der Ansprüche 1 oder 2, dadurch gekennzeichnet, daß das Einkapselungsprodukt (36) ein halbfestes Harz ist.

4. Verfahren nach einem der Ansprüche 1 bis 3, dadurch gekennzeichnet, daß das erste Volumen (V'$_1$) derart ist, daß die Mikroschaltung (30) und daß die elektrischen Verbindungsdrähte (31) der Mikroschaltung auf dem Schaltungsträger (21) ganz vom Einkapselungsprodukt eingekapselt sind.

5. Mikroschaltungskarte mit einem Kartenträger (9) mit einer Lagerstelle (2), in der ein elektronisches Modul (20) befestigt wird, das einen Schaltungsträger (21) und wenigstens eine Mikroschaltung (30) auf einer Innenfläche des Schaltungsträgers in Richtung auf das Innere der Lagerstelle aufweist und im Abstand von der Innenfläche (7, 8) des Lagerstellenbodens angebracht ist, dadurch gekennzeichnet, daß die Innenfläche des Bodens (6) der Lagerstelle (2) ein Gebiet mit größerer Abmessung (11) im Abstand vom Modul (20) auf wenigstens einem Teil seines Umfangs enthält, das Gebiet mit größerer Abmessung (11) einen ersten Anteil (7) der Innenfläche umgibt und selbst von einem zweiten Anteil (8) der Innenfläche umgeben wird, ein erstes Volumen (V'$_1$) zwischen dem ersten Anteil (7) und dem Modul (20) ganz von einem Einkapselungsprodukt (36) umgeben, und ein zweites Volumen (V'$_2$) zwischen dem zweiten Anteil (8) und dem Modul (20) teilweise mit dem Einkapselungsprodukt (36) gefüllt ist.

6. Mikroschaltungskarte nach Anspruch 5, dadurch gekennzeichnet, daß der erste Anteil (7) sich wenigstens senkrecht von den Lötstellen (33) auf dem Schaltungsträger der elektrischen Verbindungsdrähte zwischen der Schaltung (30) und dem Schaltungsträger (21) erstreckt.

7. Mikroschaltungskarte nach einem der Ansprüche 5

oder 6, <u>dadurch gekennzeichnet</u>, daß das Einkapselungsprodukt (36) teilweise das zweite Volumen (V'$_2$) ausfüllt und den zweiten Anteil (8) ganz umgibt.

8. Mikroschaltungskarte nach einem der Ansprüche 5 bis 7, <u>dadurch gekennzeichnet</u>, daß das Gebiet mit größerer Dicke (11) ringförmig ist.

9. Mikroschaltungskarte nach einem der Ansprüche 5 bis 8, <u>dadurch gekennzeichnet</u>, daß das Gebiet mit größerer Dicke (11) einen Dreieckquerschnitt aufweist.

10. Mikroschaltungskarte nach einem der Ansprüche 5 bis 9, <u>dadurch gekennzeichnet</u>, daß der erste Anteil (7) Verankerungselemente (40, 41) enthält.

11. Mikroschaltungskarte nach einem der Ansprüche 5 bis 10, <u>dadurch gekennzeichnet</u>, daß das Gebiet mit größerer Dicke (11) in sich geschlossen ist.

FIG.1

FIG.2

FIG.3

9

FIG.4

FIG.5